# EUROPEAN PATENT APPLICATION

(11) **EP 4 257 409 A1**
(43) Date of publication of application: **11.10.2023**
(21) Application number: 22167332.0
(22) Date of filing: 08.04.2022
(51) Int. Cl.: B60L 3/12, B60L 53/14, B60L 53/62, G01R 31/50, G01R 31/54, G01R 31/66, H02J 7/00, B60W 20/50, B60W 30/18, B60K 28/00

(54) **PARKING BRAKE MANAGEMENT SYSTEM**

(71) Applicant: Carrier Corporation, Palm Beach Gardens, FL 33418 (US)
(72) Inventor: ZARRABI, Jamal, 76520 Franqueville Saint Pierre (FR)
(74) Representative: Dehns

(57) **Abstract**

A parking brake management system for a vehicle 5, the vehicle comprising a parking brake, an electrical energy storage device 15, and a connector 12 for connecting a charging cable 11 to provide electrical energy to the electrical energy storage device 15 from an external power source 10; the parking brake management system comprising a processor 20 configured for determining whether the charging cable 11 is connected to the connector 12 by: monitoring a voltage supplied to the electrical energy storage device 15; and, monitoring an earth continuity measurement of the connector 12.

## Description

The present invention relates to a parking brake management system for a vehicle, and to a method for controlling a parking brake of a vehicle. In particular, the vehicle may be a vehicle having a connector for a charging cable providing energy from an external power source.

Electric vehicles (EV) are increasing in prominence due to the focus on renewable energy and the need to move away from the use of fossil fuels. The benefits of EVs are applicable across numerous modes of transport. For example, EVs are not only used on the road, it is also possible to use electricity to power aircraft, underwater vessels and rail vehicles.

Electric vehicles use one or more electric motors for propulsion which can be powered by various power sources, such as an on-board battery. It is necessary to charge the on-board battery at regular intervals, which can be done using multiple sources and in some instances it may be charged from other power sources on-board the EV, such as regenerative braking systems. However, typically the on-board battery will be charged at a fixed charging station which is powered by the grid.

In addition to EVs, supply chains using transport refrigeration units (TRU) require electrical systems for charging the refrigeration units. The refrigeration units maintain a desired temperature within their container using a refrigeration system powered by an electric motor. The electric motor for the refrigeration system can be charged using the same, or similar, charging station used to power EVs. In particular, the drive vehicle for refrigeration transport unit can also be electrically powered.

When an electric vehicle or a refrigeration unit is being charged, it requires a charging cable connected to a connector on the EV or TRU, which is connected to an electric terminal fixed to the ground or a nearby building. In addition, the charging cable may be operated by a person monitoring the charging process, and this person may be different to the person driving the EV or TRU. Alternatively, the charging cable may be operated by the person driving the EV or TRU, but in many instances the vehicle may be left to charge overnight.

In light of this, a person intending to drive the EV or TRU may be unaware that their respective vehicle is being charged, or that it has a cable connected to it. Therefore, there is a risk that a person driving the EV or TRU may begin driving their respective vehicle while the vehicle is still being charged, or otherwise while the charging cable is still connected.

If this happens it can cause serious damage. For instance, the charging cable may be cut free due to the force exerted on it as the EV or TRU is driven away. If the charging cable is still connected to the electric terminal, but free from the EV or TRU, it can lead to a person monitoring the charging process being seriously injured through electric shocks.

Similarly, if the charging cable is still connected to the EV or TRU, but free from the electric terminal, the cable can cause damage to other cars or people on or near the roadways.

Viewed from a first aspect, there is provided a parking brake management system for a vehicle, the vehicle comprising a parking brake, an electrical energy storage device, and a connector for connecting a charging cable to provide electrical energy to the electrical energy storage device from an external power source; the parking brake management system comprising a processor configured for determining whether the charging cable is connected to the connector by: monitoring a voltage supplied to the electrical energy storage device; and monitoring an earth continuity measurement of the connector.

The above arrangement therefore provides an automatic detection of the charging cable being connected or disconnected from the connector on the vehicle, since there are advantageously added checks on the status of the connector. In particular, the above arrangement is able to detect whether or not the charging cable is connected to the connector via the earth continuity measurement regardless of whether or not a voltage is being supplied from the external power source.

For example, in the instances where the circuit breaker is deactivated, and therefore no voltage is being supplied, prior systems which only detect whether voltage is present may determine that the charging cable is not connected. This is, however, not the case as the cable is physically still connected, albeit without the voltage being supplied. If the driver were to begin driving the EV or TRU in this instance, significant damage would still be caused.

Hence, the present aspect includes monitoring of the earth continuity, which is beneficial in instances where the monitored voltage is zero. By monitoring an earth continuity, the system can verify whether or not the charging cable is still connected. This may further reduce the chance of a person driving the vehicle driving away while the charging cable is still connected.

The vehicle may be an electric vehicle, wherein the movement of the electric vehicle may be powered by the electrical energy storage device. Alternatively or additionally, the vehicle may be a transport refrigeration unit. In this instance the vehicle may comprise a refrigeration unit, and the electrical energy storage device may be configured to provide electrical power to the refrigeration unit. The transport refrigeration unit may comprise a drive vehicle. The drive vehicle may be electrically powered and the electrical energy storage unit may be configured to provide electrical power for the drive vehicle. Alternatively, the drive vehicle may comprise a second electrical energy storage unit. As a further alternative, or in addition (e.g. a hybrid arrangement) the drive vehicle may be powered by an internal combustion engine.

The voltage supplied to the electrical energy storage device may be three-phase voltage. The voltage may be supplied from a charging terminal, wherein the charging terminal may be located at a depot for loading/unloading the transport refrigeration unit.

The processor may determine that the charging cable is connected to the connector if the monitored voltage supplied to the electrical energy storage device is greater than zero. Where three-phase voltage is used then processor may be configured to monitor each voltage phase of the three-phase voltage.

Although the processor is advantageously capable of also monitoring an earth continuity measurement of the connector, if a voltage is detected by the processor, the processor may not then monitor the earth continuity measurement. In this instance, the presence of a voltage can provide sufficient information to the processor that the charging cable is connected to the connector.

However, it will be appreciated that even if the monitored voltage supplied to the electrical energy storage device is greater than zero, the processor may be operated to also monitor an earth continuity of the connector, and in line with the first aspect the processor in any event always has the capability of monitoring an earth continuity of the connector. This further check may provide further validation to the processor regarding whether or not the charging cable is connected. This may be beneficial in case there is an error in the monitoring of the voltage being supplied.

The processor may be configured to monitor the earth continuity measurement of the connector if the monitored voltage supplied to the electrical energy storage device is zero. As discussed above, in prior systems where the processor is only configured to monitor voltage, and the detected voltage is zero, the processor may determine that the charging cable is not connected. However, it is proposed herein that when the monitored voltage is zero, the processor may then monitor the earth continuity measurement as previously described.

In addition, although the processor is configured to be able to monitor both voltage supplied and earth continuity, it will be appreciated that in practice the processor may be operated to only monitor the earth continuity measurement, and not monitor voltage being supplied. However, under most circumstances, the processor may be operated to monitor voltage being supplied fist, and then if the monitored voltage is zero, the processor may then be operated to monitor the earth continuity measurement.

In summary, the processor is configured for determining whether the charging cable is connected to the connector by: monitoring a voltage supplied to the electrical energy storage device; and, monitoring an earth continuity measurement of the connector, and thus the processor must have the capability of performing the monitoring of earth continuity as well as monitoring of voltage. However, it is not required that the processor always performs both monitoring steps under all circumstances. In some examples the processor may be configured to monitor the voltage supplied to the electrical current and, if the voltage is greater than zero it may be determined that the charging cable is connected. The processor may then be configured to monitor the earth continuity as further validation. If the monitored voltage supplied is zero, the processor may then monitor the earth continuity to determine whether the charging cable is connected. Alternatively, the processor may be operated to monitor the earth continuity only, without specifically also monitoring the voltage supplied to the electrical energy storage device at every stage.

The processor may be configured to monitor an earth continuity measurement of the connector by monitoring a current intensity in the earth connection of the charging cable. This may be achieved by the processor being configured to supply a current to the earth connection in order to monitor the current intensity in the earth connection of the charging cable.

The current may be supplied by a power source located on the vehicle. The power source on the vehicle may be a battery, wherein the battery may be a battery used to power other systems of the vehicle. The processor may be configured to activate a switch in order to connect the earth connection of the charging cable to the power source.

The processor may be configured to determine that the charging cable is connected to the connector if the current intensity in the earth connection is greater than zero. Conversely, the processor may be configured to determine that the charging cable is not connected to the connector if the current intensity in the earth connection is zero.

Zero current may indicate the absence of an earth continuity which, in addition to the monitored voltage supplied to the electrical energy storage device being zero, may be used by the processor to determine that the charging cable is not connected.

In addition, regardless of whether or not the processor is configured to monitor the voltage being supplied to the electrical energy storage device, if current intensity monitored by the processor is zero, then the processor may be configured to determine that the charging cable is not connected to the connector.

If the processor determines that the charging cable is connected to the connector, the processor may be configured to prevent deactivation of the parking brake of the vehicle. Alternatively, if the processor determines that the charging cable is connected to the connector, the processor may be configured to allow deactivation of the parking brake of the vehicle.

This parking brake management system can advantageously prevent the person driving the vehicle from driving away from the external power source while the charging cable is connected to the connector on the vehicle, and may only allow them to do so once the processor has determined that the charging cable is not connected.

As will be appreciated, in instances where the person driving the vehicle is unaware that the vehicle is being charged, their first action may be to deactivate the parking brake in order to begin driving the vehicle.

The parking brake management according to the present invention is therefore beneficial as it will prevent the deactivation of the parking brake, which therefore stops the vehicle from being driven whilst the charging cable is connected. This prevents significant damage being caused to the various components, and moreover will improve the safety of the people operating the charging cable and other road users as the inherent dangers discussed above will be alleviated.

In addition to the processor being specifically configured to prevent or allow the deactivation of the parking brake of the vehicle, the processor may also be configured to display an indication to a driver of the vehicle whether or not the charging cable is connected the vehicle.

In particular, if the processor determines that the charging cable is connected to the connector, the processor may then be configured to display an indication to the driver of the vehicle that the charging cable is not connected. On the other hand, if the processor determines that the charging cable is not connected to the connector, the processor may then be configured to display an indication to the driver of the vehicle that the charging cable is not connected to the connector.

The indication to the driver may be a visual indicator which may be a coloured light or a series of text. The visual indicator may appear in a position that is clearly visible to the driver of the vehicle, for example the dashboard of the vehicle. In the case where the processor determines that the charging cable is not connected to the connector, the visual indicator may be a green light. In the case where the processor determines that the charging cable is connected to the connector, the visual indicator may be a red light.

The indication to the driver may alternatively be an audible indicator. In addition, the indication to the driver may comprise both a visual and audible indicator.

Viewed from a second aspect, there is provided a method for controlling a parking brake of a vehicle, the vehicle comprising a parking brake, an electrical energy storage device, and a connector for connecting a charging cable to provide electrical energy to the electrical energy storage device from an external power source, the method comprising: determining whether the charging cable is connected to the connector by: monitoring a voltage supplied to the electrical energy storage device; and monitoring an earth continuity measurement of the connector.

The method may further comprised determining that the charging cable is connected to the connector if the voltage supplied to the electrical energy storage device is greater than zero, and/or a current intensity in the earth connection is greater than zero.

The method may further comprise preventing deactivation of the parking brake of the vehicle.

Alternatively, the method may further comprise determining that the charging cable is not connected to the connector if the voltage supplied to the electrical energy storage device is zero, and a current intensity in the earth connection is zero.

The method may then comprise allowing deactivation of the parking brake of the vehicle.

The method may further comprise displaying an indication to a driver of the vehicle that the charging cable is connected to the connector, or displaying an indication to a driver of the vehicle that the charging cable is not connected to the connector.

The method according to the second aspect of the invention may further comprise any of the steps carried out by the parking brake management system above, such as steps carried out by the processor as described in relation to the first aspect of the invention and optional features above.

Certain embodiments of the invention will now be described, by way of example only, with reference to the accompanying drawings, in which:
Figure 1 shows a parking brake management system; and
Figure 2 shows an algorithm for use by a processor of the parking brake management system.

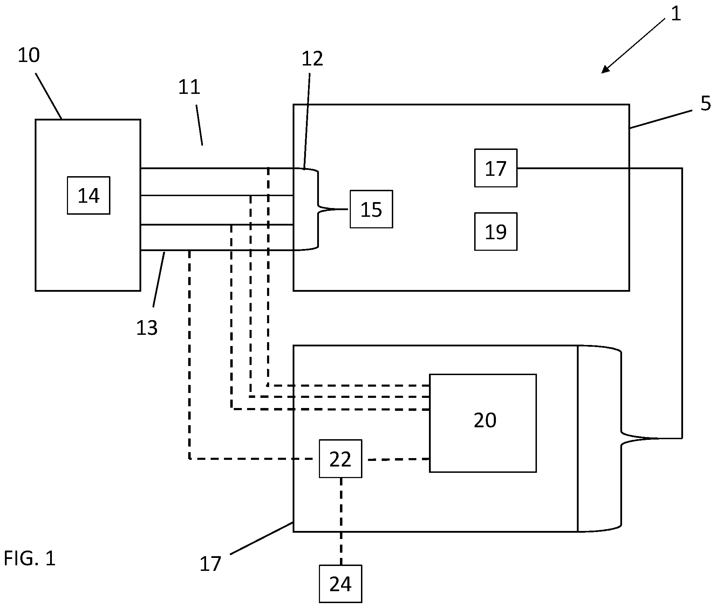

Figure 1 depicts a schematic of an electric vehicle 5 being charged at a charging station 10. The vehicle 5 may be an electric car or an electrically powered transport refrigeration unit. In the latter case, the portion of the vehicle 1 may be the transport unit, and the drive vehicle may be separate.

The vehicle 5 includes an electrical energy storage device 15 which may be a battery for driving the vehicle 5 or powering the refrigeration unit. The electrical energy storage device 15 is charged using a charging cable 11 which connects to a connector 12 of the vehicle 5. The charging cable 11 provides electrical power to the electrical energy storage device 15 from an electrical terminal 10.

The electrical terminal 10 provides three-phase voltage via a circuit breaker 10. In addition, the charging cable 11 and electrical terminal 10 comprise an earth connection 13 between the connector 12 and the ground.

In the case where the vehicle 5 is a transport refrigeration unit, the electrical terminal 10 may be located at a supply depot where the unit is loaded or unloaded.

The electrical terminal 10 may therefore be used to recharge the refrigeration unit and would be operated by a person who is different to the person driving the transport refrigeration unit.

In the case where the vehicle 5 is an electric car, the electrical terminal 10 may be located on the road-side, a service station, or a driveway for example. In this case, the drive of the vehicle 5 may operate the charging cable, but they may leave the vehicle to charge overnight.

In both cases, it will be appreciated that there may be instances where the driver returns to the vehicle 5 and is unaware that the charging cable 11 is connected to the connector 12 of the vehicle. Hence, they may begin driving the vehicle which would cause damage to the various components of the system and may further cause injury to either the operator of the charging cable 11 or other road users.

The vehicle 5 further comprises a parking brake management system 17, shown in more detail towards the bottom of Fig. 1. The parking brake management system 17 includes a processor 20, which is configured to determine whether the charging cable 11 is connected to the connector 12.

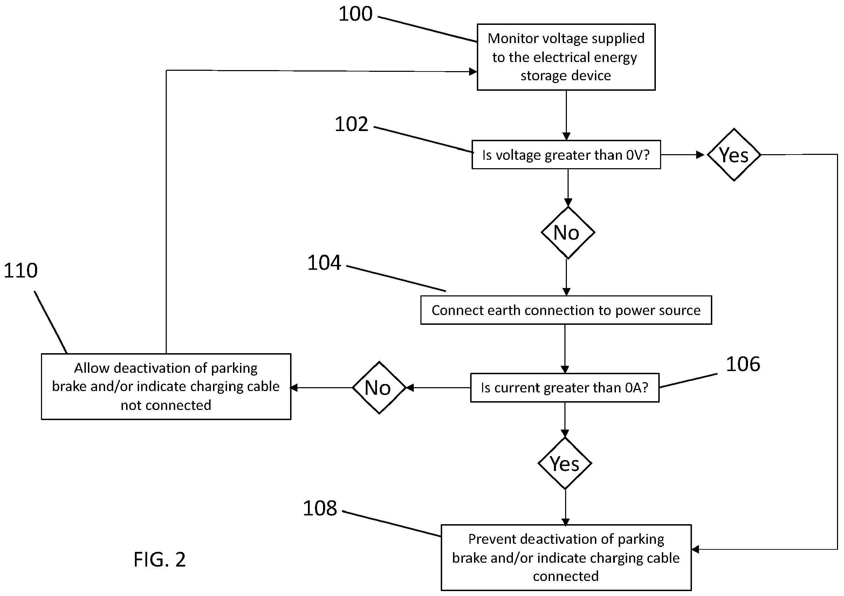

Fig. 2 depicts a flow chart showing the algorithm used by the processor 20 to determine whether the charging cable 11 is connected to the connector 12. This operation of the processor 20 will be described with reference to both Figs. 1 and 2 in combination.

Initially the processor 20 will monitor 100 the three-phase voltage provided to the connector 12 via the charging cable 11. The processor 20 will then determine 102 whether the three-phase voltage being supplied to the connector 12 is greater than 0V.

If the three-phase voltage is greater than 0V, the processor 20 is configured to determine that the charging cable 11 is connected to the connector 12 on the vehicle.

In this instance, the processor 20 will prevent deactivation 108 of the parking brake, which will prevent the driver from driving the vehicle away while the charging cable 11 is connected to the connector 12. In addition to preventing deactivation of the parking brake, the processor 20 may also indicate to the driver that the charging cable 11 is connected. This indication is provided in the driver cabin 19 of the vehicle and may either be a visual indicator, in the form of a red light, or an audible indicator.

If at step 102 the processor 20 determines that the three-phase voltage is zero, the processor 20 will then activate a switch 22 in order to connect 104 the earth line 13 of the charging cable 11 to a power source 24 capable of providing a current to the earth line 13. In the case of the three-phase voltage being zero, this may be due to the fact that the charging cable is not physically connected to the connector, or it may be that the circuit breaker is open and no power is being supplied to the charging cable 11, but the charging cable 11 is still physically connected to the connector 12.

Once the earth line 13 is connected to the power source 24, the processor 20 is configured to monitor the current intensity in the earth line 13 to detect an earth continuity. If the current intensity is greater than 0A, then the processor 20 is configured to prevent deactivation 108 of the parking brake, which will prevent the driver from driving the vehicle away while the charging cable 11 is connected to the connector 12. In addition to preventing deactivation of the parking brake, the processor 20 may also indicate to the driver that the charging cable 11 is connected. This indication is provided in the driver cabin 19 of the vehicle and may either be a visual indicator, in the form of a red light, or an audible indicator.

If the current intensity in the earth line 13 is zero, then the processor 20 is configured to allow deactivation 110 of the parking brake as this indicates that the charging cable 11 is not connected to the connector 12. The driver would then be allowed to begin driving the vehicle 5.

In addition to allowing deactivation of the parking brake, the processor 20 may also indicate to the driver that the charging cable 11 is not connected. This indication is provided in the driver cabin 19 of the vehicle and may either be a visual indicator, for example in the form of a green light, or an audible indicator.

## Claims

1. A parking brake management system for a vehicle, the vehicle comprising a parking brake, an electrical energy storage device, and a connector for connecting a charging cable to provide electrical energy to the electrical energy storage device from an external power source;
the parking brake management system comprising a processor configured for determining whether the charging cable is connected to the connector by:
monitoring a voltage supplied to the electrical energy storage device; and,
monitoring an earth continuity measurement of the connector.

2. A parking brake management system as claimed in claim 1, wherein the vehicle comprises a refrigeration unit, and wherein the electrical energy storage device is configured to provide electrical power to the refrigeration unit.

3. A parking brake management system as claimed in claim 1 or 2, wherein the voltage supplied to the electrical energy storage device is a three-phase voltage.

4. A parking brake management system as claimed in any preceding claim, wherein the processor is configured to determine that the charging cable is connected to the connector if the monitored voltage supplied to the electrical energy storage device is greater than zero.

5. A parking brake management system as claimed in any preceding claim, wherein the processor is configured to monitor the earth continuity measurement of the connector if the monitored voltage supplied to the electrical energy storage device is zero.

6. A parking brake management system as claimed in any preceding claim, wherein the processor is configured to monitor an earth continuity measurement of the connecter by monitoring a current intensity in the earth connection of the charging cable.

7. The parking brake management system as claimed in claim 6, wherein the processor is configured to supply a current to the earth connection in order to monitor the current intensity in the earth connection of the charging cable.

8. The parking brake management system as claimed in claim 6 or 7, wherein the processor is configured to determine that the charging cable is connected to the connector if the current intensity in the earth connection is greater than zero.

9. The parking brake management system as claimed in any preceding claim, wherein if the processor determines that the charging cable is connected to the connector, the processor is configured to prevent deactivation of the parking brake of the vehicle.

10. The parking brake management system as claimed in any of claims 1 to 8, wherein if the processor determines that the charging cable is not connected to the connector, the processor is configured to allow deactivation of the parking brake of the vehicle.

11. The parking brake management system as claimed in claim 9 or 10, wherein the processor is configured to display an indication to a driver of the vehicle of whether or not the charging cable is connected to the connector.

12. A method for controlling a parking brake of a vehicle, the vehicle comprising a parking brake, an electrical energy storage device, and a connector for connecting a charging cable to provide electrical energy to the electrical energy storage device from an external power source, the method comprising:
determining whether the charging cable is connected to the connector by:
monitoring a voltage supplied to the electrical energy storage device; and
monitoring an earth continuity measurement of the connector.

13. The method as claimed in claim 12, wherein the method comprises determining that the charging cable is connected to the connector if the voltage supplied to the electrical energy storage device is greater than zero, or a current intensity in the earth connection is greater than zero.

14. The method as claimed in claim 13, wherein the method comprises preventing deactivation of the parking brake of the vehicle.

15. The method as claimed in claim 13 or 14, wherein the method comprises displaying an indication to a driver of the vehicle that the charging cable is connected to the connector, or displaying an indication to a driver of the vehicle that the charging cable is not connected to the connector.
